Europäisches Patentamt

(19) European Patent Office

Office européen des brevets

(11) Publication number: **0 129 159**
**A1**

(12) # EUROPEAN PATENT APPLICATION

(21) Application number: **84106522.0**

(22) Date of filing: **07.06.84**

(51) Int. Cl.³: **C 30 B 13/24**
**C 30 B 29/60**

(30) Priority: **09.06.83 FR 8309611**

(43) Date of publication of application:
**27.12.84 Bulletin 84/52**

(84) Designated Contracting States:
**AT BE CH DE FR GB IT LI LU NL SE**

(71) Applicant: **Gleizes, Raymond Marc Xavier**
**73 les Mélèzes**
**F-95680 Montlignon(FR)**

(71) Applicant: **RYFFEL Limited**
**36 Waterloo Road**
**Dublin 4(IE)**

(72) Inventor: **Arnaud, Jean Pierre Alfred**
**23, rue de Pontoise**
**F-95160 Montmorency(FR)**

(74) Representative: **Arnaud, Jean Pierre Alfred**
**94 rue Saint Lazare**
**F-75009 Paris(FR)**

(54) **Process and apparatus for production of monocrystalline and macrocrystalline layers, by example for photovoltaic cells.**

(57) The invention relates to production of macrocrystalline and monocrystalline layers. It includes irradiating a polycrystalline layer by sweeping the surface of said layer with a beam focused along a line having a constant power density. Layer material melts in all its thickness but is not vaporised at its outer surface. Material solidifies by forming macrocrystals or, if a seed is provided, a monocrystal.
The process is useful for photovoltaic cells.

EP 0 129 159 A1

Process and apparatus for production of monocrystalline
and macrocrystalline layers, by example for photovoltaic
cells

Technical field

The invention relates to production of monocrystalline and macrocrystalline layers. It especially relates
to production of thin monocrystalline layers, by example
of silicon, on a substrate which may be insulating or conductive and which can be provided with a reflecting or non-
reflecting coating. It also relates to an apparatus for
production of such layers. It also relates to devices
including such thin monocrystalline or macrocrystalline
layers on substrate, and especially devices having a monocrystalline or macrocrystalline silicon layer. It also relates
to integrated circuits and photovoltaic cells prepared
with such semi-conductor devices including monocrystalline
or macrocrystalline layer.

In the specification and in claims, the expression
"monocrystalline" relates to a material having a grain size
above some centimeters, the expression "macrocrystalline"
relates to a material having a grain size at least equal
to 100 micrometers, and the expression "polycrystalline"
relates to a material having a grain size under some micrometers.

The following specification relates to production
of monocrystalline or macrocrystalline silicon layers
from thin layers of amorphous or polycrystalline silicon.
This example is selected because of its great technological
importance, as such monocrystalline or macrocrystalline
layers allow producing integrated circuits and photovol-
taic cells. However, the invention is not restricted to
this application and is generally suitable to all materials
which can be at a monocrystalline or macrocrystalline
state, and essentially to materials whose production at
monocrystalline state is yet known, by example by pulling
processes.

Background of the invention and prior art

French patent n° 2 130 662 discloses a process for producing thin crystalline layers with high homogeneity and high purity. According to this process, an amorphous, monocrystalline or polycrystalline layer with a poor chemical purity is scanned progressively by a high power beam, by example laser beam, so that it melts and then recrystallizes. Scanned beam may have a strip section. Scanning is slow (1-5 cm/h) for providing to migration of impurities and for allowing purity increase.

Published German patent application n° 2 723 915 discloses a similar process for purificating in which a laser beam is provided for scanning at a speed between 0,36 cm/h and 1,2 cm/min.

German patent n° 2 638 269 discloses a process for recrystalization with a low speed of about some centimeters by minute. German patent application n° 2 917 353 also discloses a process for recrystallizing by providing a low temperature gradient obtained with a low power density. This process is also very slow. A drawback of these slow processes for recrystallizing is that the main part of heating power is lost into the substrate, and that reactions at interfaces of material to be recrystallized and of its substrate have enough time to produce undesirable compounds, also with a great diffusion of impurities.

French patent application n° 2 432 768 discloses a process for producing integrated circuits in which an interconnection pattern consisting in a conductive material, by example polycrystalline silicon, is treated by laser radiation or electron beam having enough power to melt conductive material (polycrystalline silicon) during a short enough period for conductive material to do not significantly flow. The specification discloses applying helium-neon laser radiation for melting polycrystalline silicon interconnections consisting of layers having a thickness of 0.5 μm. The specification does not disclose scanning of interconnection pattern but only its whole irradiation by a laser pulse. This process is for removing defects of polycrystalline silicon layers.

## Summary of the invention

The invention relates to treatment of high area layers by a focused power line. For homogeneity of treatment according to the invention, it is preferred that power density is constant all along the focusing line. Such a line can be generated as described in European patent application n° 0 098 969 filed on June 7, 1982.

According to the invention, a process for producing monocrystalline or macrocrystalline layer from a starting layer of a material having a polycrystalline or amorphous state, includes :

- forming starting layer on a substrate having a determined thermal conductivity so that, when said layer is hotter than substrate, heat is conductively lost into the substrate through layer-substrate interface,

- irradiating, through outer layer surface far from said interface, layer material included in a small area elongated in a direction included in outer surface of said layer, with enough irradiation power for layer material to melt at least in a proportion of its thickness, and

- progressively displacing said small elongated area along said layer, in a direction different from elongation direction of said small area, so that material from which said area is going away solidifies,

- irradiation power density in said small elongated area being of at least 100W/cm and preferably of at least 500W/cm, and said layer being irradiated during a period short enough for heat from said layer lost by conduction into said substrate to be at most about of the same magnitude as irradiation power effectively kept by said elongated area before solidification thereof.

It is an advantage that elongated area displacement speed is high enough for temperature of material of outer surface of said layer to be lower than vaporization temperature of said layer material. It is also an advantage that wavelength and power density on the one hand and elongated area displacement speed on the other hand are such that layer material the nearest from said substrate melts.

Displacing of a small elongated area is preferably in a substantially transverse direction.

Irradiation is preferably provided for by radiation selected between  non-coherent light focused along a line, coherent light focused along a line, or electron beam focused along a line.

Preferably, said layer is prepared on a reflecting coating of substrate , so that melting of said layer small elongated area is provided for by absorption of radiation projected to outer layer surface, surface material tending to first melt  because it is the hottest, but also by absorption of infrared rays returned from coating supported by substrate, reflecting coating being constituted by a material which is either solid or melted at melting temperature of layer material.

Preferably, starting material layer is prepared on the substrate from a powder applied on the substrate, by projection by plasma gun of a material forming a continuous layer, or by  formation of a continuous layer by vapor phase deposition,  sputtering or vacuum evaporation.

Further, process according to the invention also includes preferably, before layer melting, contacting a layer portion with a monocrystalline seed of the same material as said layer or of a material having a crystal network identical or nearly identical to network of layer material when it is in monocrystalline state, progressive displacing of small elongated area beginning from seed location.

The invention also relates to an apparatus for producing monocrystalline or macrocrystalline layers by the above process, including means for forming powder layer on a substrate, irradiation means for forming a line having a constant power density, and means for displacing relatively powder layer and power beam from irradiation apparatus.

The invention also relates to semi-conductor devices, especially photovoltaic cells and integrated circuits, produced by use of above process or apparatus.

Detailed description

The following detailed disclosure does not give details of irradiation apparatus used for forming focused line. This apparatus is described in above mentioned European patent application n° 0 098 969 which is incorporated to this specification. This apparatus substantially includes a mirror having a surface which is not of revolution and which allows a constant distribution of power from a laser beam along a focused line by a cylindrical mirror.

Thin monocrystalline or macrocrystalline layers produced according to the invention are useful for various applications and especially for production of photovoltaic cells and integrated circuits. It is known that integrated circuits and some photovoltaic cells are produced from monocrystalline silicon from silicon rods, forming wafers having a thickness of about several tenths of millimeter. However, useful area in this wafers is restricted to a surface layer of about one to several micrometers from a surface, impurities diffusion being by example provided in a layer having a depth of some thousands angströms only.

The invention relates to thin layers, that is having a thickness of some micrometers, by example from 1 to 100 μm. Obviously, said thickness can be higher or smaller in some conditions. Layers having a thickness above 100 μm have not peculiar advantages according to the invention because the more they are thick and the more they require a large power quantity for their treatment according to the invention.

Silicon is a cheap material which is very abundant, but purification treatments are very costly so that every reduction of used silicon quantity is an advantage.

Amorphous or polycrystalline silicon layers provided on a substrate before treatment according to the invention, that is before conversion to monocrystalline or macrocrystalline state, may be prepared according to every process. The man in the art very well knows all these processes and so they are not described in detail. It can be considered by example vapor phase chemical deposition , vacuum evaporation, different sputterings , by example by ion beam, in a plasma or with a magnetron, applying a thin powder layer on a substrate, and forming a layer by projection of silicon with plasma gun. All these processes allow to adjust thickness and quality of layer. It is to be emphazised that these processes also allow simultaneous deposition of impurities, like phosphor or boron so that silicon can have the desired conductivity type n or p and have the desired resistivity.

In a preferable embodiment of the invention, material layer having an amorphous or polycrystalline state is a layer of a flowing powder, prepared from every process suitable in view of type and size of powder, by example by doctor blading or by application by transfer tape. Powder layer can be applied electrostatically when material properties allow such a process. Some deposition processes required a conductive powder and other an insulating powder. It is also known that some processes require use of a conductive substrate and other of an insulating substrate. All these processes, known for forming a powder layer, can be used if they are corresponding to properties of material to be applied in powder form and to substrate properties.

General features of these processes are not described because they are used in the common manner.

Powder layer may also be produced by settling, that is by suspending powder in a liquid carrier, by settling powder on substrate, and by separating substrate having a powder layer from the liquid carrier. Separating step can be provided for by evaporation of liquid carrier.

A powder layer is preferable to layers produced by other processes. Because powder has practically no effect on substrate before use of the process according to the invention, said substrate can previously be provided of a very thin deposit useful for production of rectifying contact or for migration of an impurity through rear surface of layer in a following step.

One of the most useful of the above mentioned processes according to the invention is projection of silicon powder suitably doped. This process is advantageous because it allows forming quickly and cheaply solid layers with a purity suitable for photovoltaic cells on nearly any substrate, especially on tinned steel.

Various problems are presented by substrate according as to wether treatment is only by absorption through outer surface only, or is complemented by power recovering through reflection.

In the first case, radiation is projected into layer surface. As radiation presents loss by surface reflection, of about a quarter of incoming power in the case of silicon, three quarters only of power are transmitted to material. However, when the layer has to melt in all its thickness, the portion nearest of substrate has to melt, that is to receive enough power to be elevated to melting temperature and to be converted into melted state (latent heat of melting), but material of outer surface is not allowed to go above vaporisation temperature. So, in the case of silicon, a quarter only of incoming power is used for melting said layer. The remaining is lost by reflection by surface or by absorption into substrate.

In the other case, that is when losses into substrate are reduced by partial reflection at layer-substrate interface, above condition (the portion nearest of the substrate being melted but outer surface temperature lower than vaporisation temperature) allows use of a greatly higher proportion of incoming radiation of laser beam. This second process is then advantageous relatively to the first one.

In above considerations, it is assumed that radiation absorption and consequently corresponding thin layer temperature elevation are quick enough for temperature gradient in said layer to be very steep. High gradient requires high power density. According to a feature of the invention, melting of said small layer area which is progressively moved, is provided during a time short enough for power

0129159

loss through conduction to be either unsignificant or at least of about the same magnitude as effectively absorbed heat. (In this specification the expression "of about the same magnitude" means that heat losses through conduction during irradiation are not higher than about 20 times effectively required power for layer melting without conduction losses).

When said substrate is a very good heat conductor, conduction losses may be too high for the process according to the invention to be used with power densities which can be readily obtained. So, it is preferable for the substrate, at least in its portion which contacts silicon, to do not be a very good heat conductor. This feature can be obtained through several means. Firstly, substrate may be relatively insulated (silica glass, alumina and other ceramics). When said substrate is provided of a reflecting coating, said coating may be thin so that its heat capacity is very low and that insulating substrate under coating constitute a sufficient protective barrier. Reflecting coating can also be a relativelty poor conductor. Best materials which are solid at melting temperature of silicon and useful as such are chrome and titanium. However, in a preferable embodiment, reflecting material is a layer of a low melting temperature metal. Said metal may be lead or tin or preferably lead-tin alloy, including possibly other alloying metals. The advantage of use of such a low melting temperature metallic material is that it quickly converts to melted state and then has a heat conductivity very lower than that of solid corresponding metal. Consequently, this melted metallic material constitutes a thermal insulation layer. Time required for melting may be low enough for silicon doping by metallic material to be unsignificant.

Obviously, treatment is easier when substrate or coating has a low heat conductivity, because the period during which each portion of said layer remains at melted state may be extended and radiation power density may be reduced.

Examples of substrate useful according to the invention are insulating subtrates, such as ceramics and some glasses, insulating substrates with a conductive coating ($SnO_2$,...), insulating substrates coated by a very thin layer of a metal which remains at solid state at melting temperature of silicon (chrome, titanium, etc.), metallic substrates having a good or a poor heat conductivity, coated by a relatively thick layer (by example several microns) of a metal or alloy having a low melting temperature (lead, tin,...), and metallic substrates without coating, if their material has a low melting temperature and consitutes a thin surface layer which is melted during treatment according to the invention.

Obviously, irradiation conditions have to be tailored to specific substrate-layer pair, because unmatched conditions may bring a separation of layer from substrate or cracking of treated layer.

Radiation absorption by layer material is essential. Radiation not only has to have a sufficient power density, but also its wavelength should be such that absorption coefficient of material at this wavelength is suitable. When silicon is considered and in view of relatively high power density which must be used, radiation sources the most advantageous (for their power) are carbon dioxide $CO_2$ molecular lasers. They currently have their higher power at a wavelength of 10,6μm. Because they can be used continuously and their energy is cheap, compared with energy from other lasers, used wavelength is preferably this of such a laser that is 10,6μm. However, other radiations can be used if they correspond to all requirements above indicated.

Absorption coefficient and thin layer thickness are preferably selected so that power quantity which can be used for melting is optimized. In case of silicon and generally other semi-conductors, absorption coefficient can be adjusted in a great range because it much varies with resistivity (multiplying resistivity by 10 corresponds to multiplying absorption coefficient by 50 or 100). Then, there is relationship between absorption coefficient and layer thickness giving optimal conditions. Optimal layer thickness is lower when absorption coefficient is higher. Absorption coefficient is very variable with layer temperature and also with doping impurity type. In following examples, impurity type and approximative concentration are indicated, with resistivity measured at ambient temperature.

In spite of high temperature of silicon during treatment (temperature above melting temperature, material being in liquid state) and in spite of melted state of substrate or coating portion which contacts silicon, in some embodiments, diffusion phenomena are practically unsignificant because silicon is melted during a very short time (from some tens or hundreds of microseconds to at most ten or twenty milliseconds). It also appears that impurities which are initially uniformly distributed in silicon body remain uniformly distributed in all silicon body. This feature is important because selection of starting material purity is easier.

As indicated in the above disclosure, said treatment requires a very high intensity beam sweeping polycrystalline or amorphous layer. First, sweeping cannot be provided by a pinpoint focused beam, because treatment is not then uniform. So, radiation must form a beam focused along a line segment having a substantially constant power density, and this line segment must regularly sweep thin layer surface. In view of previously indicated parameters, in silicon treatment, focused line must have a power density of at least 100 W/cm and preferably at least 500 W/cm, focused line having a width of about 0,3 mm at sweeping location along thin layer, line segment length depending from power available. Above mentioned European patent n° 0 098 969 discloses an irradiation apparatus suitable for forming such a line segment.

It is also known that,when a polycrystalline material is sweeped by a power beam without crystalline seed, polycrystalline material grains constitute seeds and

0129159

provide for a progressive growth of grains and, after a relatively short displacement, material converts either to monocrystalline or macrocrystalline state (that is includes only a very small number of monocrystals), such macrocrystalline material having practically the same properties as monocrystalline materials in photovoltaic cells.

This behaviour shows that it is not required that melted area completely separates monocrystalline material which has just been formed from polycrystalline material which will be melted during small elongated area displacement. Consequently, it is not required that layer material is melted in the whole thickness of said layer.

Before describing peculiar examples of embodiments of the invention, a special embodiment having a considerable practical advantage is considered. It has been indicated that use of a reflecting coating disposed between substrate and silicon is preferable. Chrome and titanium are very preferable metals in this context. However, when they form relatively thick layers (some micrometers), they are good conductors of heat and consequently they induce high heat losses. According to the invention, substrates coated by silicon can be preheated to a relatively high temperature. By example, when devices to be generated must be further used in a diffusion step, by example for photovoltaic cell production, treatment according to the invention can be executed just before diffusion step. So, in view of high substrate temperatures, heat losses through conduction are drastically reduced. This embodiment allows use of substrates and coatings having a heat conductivity which is relatively high. Following example 3 corresponds to such a preheating example.

It is now considered some specific examples of embodiments of the invention. Irradiation apparatus includes a 3 kW $CO_2$ laser having a beam energy distribution such that it constitutes a focused line segment having a length of 7 mm and a width of 0,5 mm, power density along said line segment being uniform and of about 3100 W/cm.

EXAMPLE 1

A layer of n-type silicon doped by phosphor atoms, having a thickness of about 30μm is prepared on a fused silica substrate. Phosphor concentration is about $10^{18}$ atoms/cm$^3$. Such a concentration is not exactly defined because of possible variation during vapor phase chemical deposition used for its preparation. Resistivity of obtained layer is of about 0,02 Ω.cm at ambient temperature.

Several substrates are successively displaced with different speeds. It is found that a substrate having a speed of about 13 cm/s has a macrocrystalline layer after treatment.

EXAMPLE 2

Substrate is now a steel substrate coated with practically pure tin layer having a thickness of 20μm. Silicon is coated with a plasma gun.

Silicon layer has a thickness of about 40μm. Silicon is p-type silicon doped by $2.10^{18}$ atoms/cm$^3$ of boron. Resistivity is about 0,05 Ω.cm.

It is found that a macrocrystalline silicon layer is obtained when substrate is displaced at a speed of about 25 cm/s.

EXAMPLE 3

Substrate is a steel substrate coated by titanium. Titanium layer has a thickness of about 8 to 10 μm.

Substrate is disposed on the bottom of a flat bottom vessel and a suspension of a fine silicon powder in ethylether is poured in said vessel. All silicon powder particles have a size less than 0,4 μm. Vessel is disposed in a laboratory hood and ethylether is evaporated after some minutes. Substrate then carries an uniform silicon powder layer having a thickness of about 100μm. Thickness can be modified by variation of silicon concentration of suspension and of suspension quantity poured in vessel. After treatment according to the invention, layer thickness is about 40 μ. Silicon is n-type silicon doped by about $5.10^{18}$ atoms/cm$^3$ of phosphor. Resistivity is about 0,01 Ω.cm.

Apparatus used for treatment also includes a preheating furnace disposed near area for treatment by focused laser line. So, substrate is preheated at about 1250°C in such a manner as to simulate diffusion conditions of an impurity for forming junctions near surface. Substrate is then displaced at the level of focused line segment with a great speed. Obtained layer is macrocrystalline when said speed 30 cm/s.

Other experiments show that monocrystalline layers can be obtained when a crystalline seed is used. Obtained layers can be subjected to common diffusion steps and metallizing steps, during photovoltaic cell production, metallic coating which is possibly carried by substrate constituting preferably one of the electrodes.

In preceding  examples, used substrates have relatively small width, of about some centimeters. However, their length is not restricted. So, as examples 2 and 3 show that steel substrate can be used, substrate can be constituted by a continuous strip on which silicon layer is continuously deposited.

Above examples indicate that treated layer width is of about 7 mm. However, other widths can be used with irradiation segment line having corresponding length. By example, a 10 kW laser allows treatment of a layer having a width above 100 mm, on a tinned steel substrate. If treated width obtained during one pass is unsufficient, parallel areas can be treated in said layer during several passes.

Above embodiments of the invention have been described in reference to a $CO_2$ laser beam, but other lasers can be used. Moreover, irradiation line segment can be constituted by electrons. This embodiment is not described because electron beam treatment requiring to work under vacuum is known by the man in the art.

Industrial working possibilities

The invention can be used in all applications which require a modification of crystalline state of a thin layer. Main industrial areas which are concerned are semi-conductor plants and photovoltaic cell  production companies.

## CLAIMS

1.      Process for production of monocrystalline or macrocrystalline layer from a starting layer of a material at a polycrystalline or amorphous state, characterized in that it includes :

- forming a starting layer on a substrate having a determined heat conductivity so that, when said layer is hotter than substrate, it induces losses through conduction into substrate at the interface layer-substrate,

- irradiation, through outer layer surface far from said interface, of layer material included in a small area elongated in a direction included in an outer surface of said layer, with enough irradiation power for layer material to melt at least in a proportion of its thickness, and

- progressively displacing said small elongated area, in a direction different from elongation direction of said small area, so that material from which said area is going away solidifies,

- irradiation power density in said small elongated area being of at least 100 W/cm and preferably of at least 500 W/cm and said layer being irradiated during a period short enough for conduction heat losses from said layer into said substrate to be at most of about the same magnitude as irradiation power effectively kept by said elongated area before solidification thereof.

2.      Process according to claim 1, characterized in that displacement speed of said small elongated area is high enough for temperature of material of the layer outer surface to be lower than vaporization temperature of said layer material.

3.      Process according to claim 2, characterized in that radiation wavelength, irradiation power density and displacement speed of said small area are such that material the nearest from said substrate melts.

4.      Process according to anyone of claims 1 to 3, characterized in that displacement of said small elongated area is in a substantially transverse  direction.

5.      Process according to anyone of preceding claims, characterized in that irradiation is provided for by radiation selected between non-coherent light focused along a line, coherent line focused along a line, and electron beam focused along a line.

6.      Process according to anyone of preceding claims, characterized in that said layer is prepared on a reflecting coating carried by said substrate, so that melting of said small elongated area is provided by absorption of radiation projected at outer surface of said layer and by absorption of radiation returned by reflecting coating carried by said substrate, said reflecting coating being of a material which is either solid or melted at melting temperature of layer material.

7.      Process according to anyone of preceding claims, characterized in that forming starting material layer on a substrate includes forming a powder layer on said substrate, forming a continuous layer by projection with plasma gun, or forming a continuous layer by a process selected between vapor phase chemical deposition, sputtering and vacuum evaporation.

8.      Process according to anyone of preceding claims, characterized in that it also includes, before layer melting, contacting a layer    portion with a monocrystalline seed of layer material or of a material having a crystalline network identical or nearly identical to network of layer material when it is in monocrystalline state, progressive displacing of small elongated area beginning from seed location.

9.      Apparatus for producing monocrystalline or macrocrystalline layers by a process according to anyone of preceding claims, characterized in that it includes :

        - means for forming powder layer on a substrate,

        - irradiation means for forming a line having a constant power density, and

        - means for relativelty displacing powder layer and power beam from irradiation apparatus.

10.      Semi-conductor device, by example photovoltaic cell, characterized in that it is prepared by a process according to anyone of claims 1 to 8.

## EUROPEAN SEARCH REPORT

European Patent Office

## DOCUMENTS CONSIDERED TO BE RELEVANT

| Category | Citation of document with indication. where appropriate, of relevant passages | Relevant to claim | CLASSIFICATION OF THE APPLICATION (Int. Cl. ³) |
|---|---|---|---|
| X,Y | DE-A-2 638 269 (WACKER-CHEMITRONIC) * Claim; page 12, paragraph 1; page 14, paragraph 3; figure * | 1-5,7, 9 | C 30 B 13/24 C 30 B 29/60 |
| D,X Y | LU-A- 65 027 (SIEMENS) * Claims; figures * | 1,2,4, 5,7,8, 9 | |
| X,Y | DE-A-2 917 353 (DORNIER SYSTEM) * Claims; figures * | 1,3,4, 5,7,8 | |

TECHNICAL FIELDS SEARCHED (Int. Cl. ³)

C 30 B 13/24
C 30 B 13/00
C 30 B 29/60

The present search report has been drawn up for all claims

| Place of search THE HAGUE | Date of completion of the search 14-09-1984 | Examiner BRACKE P.P.J.L. |
|---|---|---|